Europäisches Patentamt

European Patent Office

Office européen des brevets

(11) Veröffentlichungsnummer : **0 019 912**
**B1**

(12) # EUROPÄISCHE PATENTSCHRIFT

(45) Veröffentlichungstag der Patentschrift :
**16.02.83**

(51) Int. Cl.³ : **H 01 J 29/00, H 04 N 5/33**

(21) Anmeldenummer : **80102969.5**

(22) Anmeldetag : **28.05.80**

(54) **Wärmebildaufnahmeplatte.**

(30) Priorität : **30.05.79 DE 2922048**

(43) Veröffentlichungstag der Anmeldung :
**10.12.80 Patentblatt 80/25**

(45) Bekanntmachung des Hinweises auf die Patenterteilung : **16.02.83 Patentblatt 83/07**

(84) Benannte Vertragsstaaten :
**FR GB**

(56) Entgegenhaltungen :
**DE A 2 223 288**
**US A 2 280 946**
**US A 3 324 327**
**US A 3 495 117**

(73) Patentinhaber : **Heimann GMBH**
**Weher Köppel 6**
**D-6200 Wiesbaden 1 (DE)**

(72) Erfinder : **Steinhage, Peter-Wilhelm Dr. Dipl.-Phys.**
**Am Langels-Weinberg 4**
**D-6200 Wiesbaden (DE)**

(74) Vertreter : **Mehl, Ernst, Dipl.-Ing.**
**Postfach 22 01 76**
**D-8000 München 22 (DE)**

EP 0 019 912 B1

Wärmebildaufnahmeplatte

Die Erfindung betrifft eine Wärmebildaufnahmeplatte, mit einer Umsetzschicht, in der über einen physikalischen Umsetzeffekt aus der einem Wärmebild entsprechenden und örtlich verteilt auftreffenden thermischen Strahlung ein entsprechendes Bild örtlich verteilter Eigenschaft erzeugt wird, wie z. B. über einen pyroelektrischen Effekt ein Ladungsbild, d. h. ein Bild mit örtlich verteilter elektrischer Ladung, bei der die Umsetzschicht zum Verhindern seitlicher Wärmeleitung und der damit verbundenen Bildunschärfe durch Unterbrechungen im Material gerastert ist und bei der die Rasterung der einfallenden Wärmestrahlung zugekehrt ist.

Eine solche Wärmebildaufnahmeplatte dient im allgemeinsten Sinn als Empfänger eines thermischen Bildes, das über eine optische Vorrichtung auf die Platte abgebildet wird und dort durch Absorption und Erwärmung ein entsprechendes örtlich verteiltes Temperaturrelief erzeugt. Die Wärmebildaufnahmeplatte hat als wesentlichen Bestandteil eine Umsetzschicht als Träger des Temperaturreliefs, die das Temperaturrelief in ein Relief verwertbarer Eigenschaft übersetzt. Das kann je nach verwendetem Material über den genannten pyroelektrischen Effekt ein örtlich verteiltes Ladungsrelief sein, aber auch über einen thermoelektrischen Effekt ein Spannungsrelief gegenüber einer Grundelektrode, oder über einen thermoresistiven Effekt ein Bild örtlich verteilten elektrischen Widerstandes. Nicht nur elektrische Größen als Bildinhalt sind denkbar; es können auch andere sein wie z. B. eine von der Wärmestrahlung erzeugte örtliche Verteilung des optischen Brechungsindexes. Abhängig von der für die jeweilige Verwendung günstigen Auswertbarkeit wird man den geeigneten Effekt wählen.

Abgesehen von einer reinen Umsetzung des Wärmebildes in ein mit dem Auge sichtbares Bild ist die gängigste Auswertung des erzeugten Bildes das Abtasten über einen scharf gebündelten Elektronenstrahl in einer Bildaufnahmeröhre, der aus dem Bild ein zeitlich entsprechend verlaufendes elektrisches Signal erzeugt. Dieses wird entweder gespeichert oder über eine Bildröhre als sichtbares Bild dargestellt.

Der Aufbau des Temperaturreliefs durch die auf die Wärmebildaufnahmeplatte abgebildete Wärmestrahlung erfolgt nach einer Exponentialfunktion. Es muß einerseits genügend Zeit gegeben werden, damit sich das Temperaturrelief in der Umsetzschicht aufbauen kann und eine genügende Intensität des durch die Umsetzschicht erzeugten Bildes ermöglicht. Andererseits ist die Bildschärfe bestimmt durch die laterale Wärmeleitfähigkeit der Umsetzschicht bzw. der noch vorhandenen aufgebrachten Schichten. Die aufgebauten lokalen Temperaturunterschiede haben entsprechend der lateralen Wärmeleitfähigkeit die Tendenz, ineinanderzufließen und damit die Bildschärfe zu verringern.

Deswegen wird üblicherweise die einfallende Wärmestrahlung zerhackt d. h. das Wärmebild periodisch über eine Modulatorblende aus- und eingeblendet und dadurch das Temperaturrelief mit der Modulationsfrequenz immer wieder neu aufgebaut. Die optische Auflösung nimmt dabei mit der Modulationsfrequenz zu, die Empfindlichkeit jedoch wegen der damit kleiner werdenden thermischen Speicherzeit ab.

Um auch mit niedrigen Modulationsfrequenzen oder auch beispielsweise bei langsamem Schwenken des Wärmebildaufnahmegeräts über die Aufnahmeszene eine möglichst lange thermische Speicherzeit und damit hohe Signalempfindlichkeit zu bekommen bei gleichzeitig hoher Bildauflösung ist es bekannt und beispielsweise in der DE-OS 22 23 288 beschrieben, die pyroelektrische Umsetzschicht einer pyroelektrischen Bildaufnahmeröhre zu rastern. Die Umsetzschicht besteht dann aus einem Mosaik aus pyroelektrischen Elementen, die voneinander getrennt auf einem Träger mit geringer lateraler Wärmeleitfähigkeit befestigt sind. Das Übersprechen der einzelnen Bildpunkte durch laterale Wärmeleitung ist dadurch reduziert. Die gerasterte Umsetzschicht kann dabei der Wärmestrahlungsseite zugekehrt sein. Der ungerasterte Träger ist dann dem abtastenden Elektronenstrahl zugekehrt. Die die einzelnen Mosaikpunkte trennenden Kanäle müssen aus Gründen der Wärmeleitung eine ausreichende Breite haben, können aber mit ihrer eingenommenen Fläche zur Signalerzeugung nichts beitragen. Da zu einer hohen Bildauflösung die Gitterkonstante der Rasterung möglichst klein sein soll d. h. das Mosaik möglichst fein, ist das Verhältnis der aktiven Umsetzschichtfläche zur passiven Kanalfläche ungünstig für eine gute Signalempfindlichkeit. Weiter bringt das Vorsehen einer Trägerschicht mit schlechter lateraler Wärmeleitfähigkeit eine Schicht mit verhältnismäßig hoher Wärmekapazität, die ebenfalls die Signalempfindlichkeit schwächt.

Der vorliegenden Erfindung liegt die Aufgabe zugrunde, angesichts dieses Stand der Technik einen besseren Aufbau einer Wärmebildaufnahmeplatte anzugeben, der in allgemeinster Anwendung eine hohe Bildauflösung ermöglicht und dabei keine Empfindlichkeitsschwächung in Kauf nehmen muß.

Zur Lösung dieser Aufgabe wird bei einer Wärmebildaufnahmeplatte der eingangs genannten Art erfindungsgemäß vorgeschlagen, daß sich die Rasterung nicht durch die gesamte Dicke der Umsetzschicht erstreckt, so daß ein wärmeleitender durchgehender Teil der Umsetzschicht gebildet ist.

Die Kanäle der Rasterung können so schmal gemacht werden, daß nur die laterale Wärmeleitung unterbrochen wird. Der Aufbau eines hochauflösenden Temperaturprofils mit hoher Empfindlichkeit ist dadurch möglich. Dabei ist es möglich, die Kanäle nur so tief wie nötig zu machen. Nach dem zeitlichen Aufbau des Temperaturprofils bis zum Grund der Kanäle und ausreichender Zeit, den Umsetzeffekt auszuwerten, kann das Temperaturprofil über den durchgehenden Teil der Umsetzschicht wieder zerfließen.

Insbesondere ist das von Vorteil bei einer Wärmebildaufnahmeplatte in folgender Ausgestaltung mit den Merkmalen :

sie wird in Verbindung mit einer das Wärmebild zeitlich zerhackenden Blende mit Dunkelphase und Hellphase verwendet ;

die Tiefe der die Rasterung bildenden Kanäle in der Umsetzschicht sowie die Stärke des durchgehenden Teils der Umsetzschicht sind so bemessen, daß sich die Einwirkung der Wärmestrahlung auf die Rasterpunkte während der Hellphase bis vor den durchgehenden Teil der Umsetzschicht durchgesetzt hat und daß sich während der Dunkelphase die örtliche Verteilung der Wärmebeeinflussung im durchgehenden Teil der Umsetzschicht ausgleicht.

Beispielsweise bei Elektronenstrahlabtastung wird das umgesetzte Wärmebild zu dem Zeitpunkt abgelesen, wo sich das Temperaturrelief bis zum Boden der Kanäle aufgebaut hat. Anschließend in der Dunkelphase der Modulatorblende verläuft das Bild im lateral wärmeleitenden durchgehenden Teil der Umsetzschicht, so daß zum Beginn der nächsten Hellphase das vorhergehende Temperaturrelief weitgehend ausgeglichen ist.

Je vollständiger der Temperaturausgleich in der Dunkelphase erfolgt, desto geringer ist die thermische Trägheit des Bildes. In einer vorteilhaften Ausgestaltung ist deswegen vorgesehen, daß die ungerasterte Seite der Umsetzschicht mit einer elektrisch isolierenden Schicht hoher Wärmeleitfähigkeit bedeckt ist.

Vorzugsweise wird eine erfindungsgemäße Wärmebildaufnahmeplatte als Target in einer Aufnahmeröhre für thermische Bilder verwendet und besteht aus pyroelektrischem oder thermoresistivem oder thermoelektrischem Material.

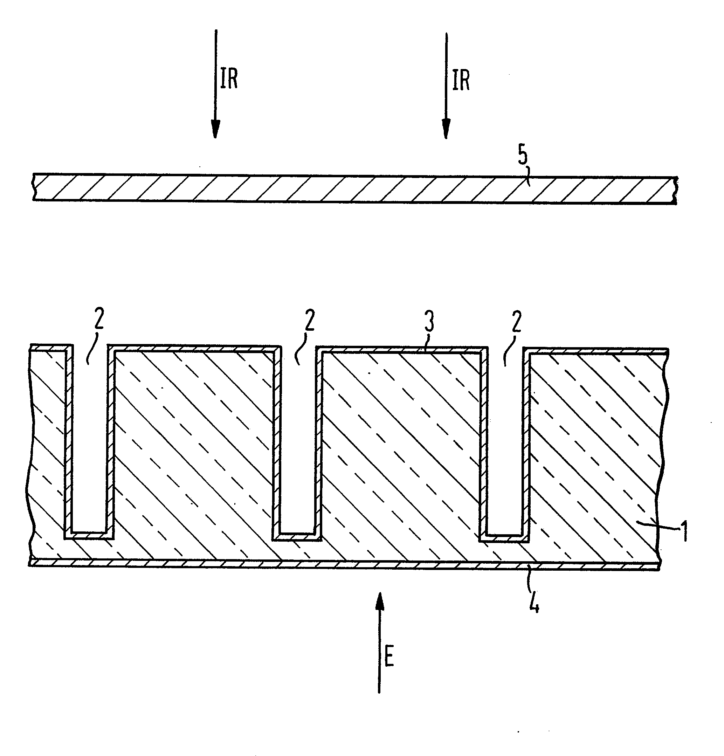

Anhand eines in der Zeichnung schematisch dargestellten Ausführungsbeispiels soll die Erfindung weiter erläutert werden. Das Ausführungsbeispiel zeigt die Anwendung in einer pyroelektrischen Bildaufnahmeröhre, deren Einzelheiten allerdings der Einfachheit halber weggelassen sind.

Mit 1 ist eine pyroelektrische Umsetzschicht aus Triglycinsulfat bezeichnet, die als Target in der nicht dargestellten Aufnahmeröhre dient und längs der Röhrenachse geschnitten dargestellt ist. Die Rasterung ist teilweise erkennbar an geschnittenen Kanälen 2, die sich von der der Wärmestrahlungsseite zugewandten Seite — mit « IR » gekennzeichnet — ins Innere der Umsetzschicht 1 erstrecken und einen schmalen durchgehenden Teil der Umsetzschicht 1 ungeschlitzt lassen. Dieser ist der Abtastseite zugewandt — mit « E » gekennzeichnet —. Über die gesamte der Wärmestrahlung zugekehrte Oberfläche der Umsetzschicht 1 einschließlich der Kanalwände und — böden erstreckt sich eine zusammenhängende, elektrisch leitende und für die Wärmestrahlung durchlässige Signalelektrode 3 aus beispielsweise Chrom-Nickel oder Titan. Die dem abtastenden Elektronenstrahl zugekehrte Seite ist mit einer durchgehenden, wärmeleitenden und elektrisch isolierenden Schicht 4 aus Aluminiumoxid bedeckt. Mit 5 ist eine vor die Umsetzschicht 1 auf der Wärmestrahlungsseite gesetzte Modulationsblende bezeichnet, die periodisch abwechselnd eine Hellphase und eine Dunkelphase erzeugt.

**Ansprüche**

1. Wärmebildaufnahmeplatte mit einer Umsetzschicht (1), in der über einen physikalischen Umsetzeffekt aus der einem Wärmebild entsprechenden und örtlich verteilt auftreffenden thermischen Strahlung ein entsprechendes Bild örtlich verteilter Eigenschaft erzeugt wird, bei der die Umsetzschicht (1) zum Verhindern seitlicher Wärmeleitung und der damit verbundenen Bildunschärfe durch Unterbrechungen im Material gerastert ist, und bei der die Rasterung der einfallenden Wärmestrahlung zugekehrt ist ; dadurch gekennzeichnet, daß sich die Rasterung nicht durch die gesamte Dicke der Umsetzschicht (1) erstreckt, so daß ein wärmeleitender durchgehender Teil der Umsetzschicht (1) gebildet ist.

2. Wärmebildaufnahmeplatte nach Anspruch 1, gekennzeichnet durch folgende weiteren Merkmale :

sie wird in Verbindung mit einer das Wärmebild zeitlich zerhackenden Blende mit Dunkelphase und Hellphase verwendet ;

die Tiefe der die Rasterung bildenden Kanäle 2 in der Umsetzschicht sowie die Stärke des durchgehenden Teils der Umsetzschicht sind so bemessen, daß sich die Einwirkung der Wärmestrahlung auf die Rasterpunkte während der Hellphase bis vor den durchgehenden Teil der Umsetzschicht durchgesetzt hat und daß sich während der Dunkelphase die örtliche Verteilung der Wärmebeeinflussung im durchgehenden Teil der Umsetzschicht ausgleicht.

3. Wärmebildaufnahmeplatte nach Anspruch 2, dadurch gekennzeichnet, daß die ungerasterte Seite der Umsetzschicht (1) mit einer elektrisch isolierenden Schicht (4) hoher Wärmeleitfähigkeit bedeckt ist.

4. Wärmebildaufnahmeplatte nach einem der Ansprüche 1 bis 3, dadurch gekennzeichnet, daß sie aus einem pyroelektrischen Material besteht und als Target in einer Aufnahmeröhre für thermische Bilder verwendet ist.

5. Wärmebildaufnahmeplatte nach einem der Ansprüche 1 bis 3, dadurch gekennzeichnet, daß sie aus einem thermoresistiven Material besteht und als Target in einer Aufnahmeröhre für thermische Bilder verwendet wird.

6. Wärmebildaufnahmeplatte nach einem der Ansprüche 1 bis 3, dadurch gekennzeichnet, daß sie aus einem thermoelektrischen Material besteht und als Target in einer Aufnahmeröhre für thermische Bilder verwendet ist.

**Claims**

1. A heat image recording plate comprising a conversion layer (1) in which, by means of a physical conversion effect, there is produced from the thermal radiation corresponding to a heat image which is incident in a locally distributed manner, a corresponding image of locally distributed characteristic, and wherein, in order to prevent lateral heat conduction and the lack of definition of the image associated therewith, the conversion layer (1) is formed by a grid of interruptions in the material, the grid being facing towards the oncoming heat radiation ; characterised in that the grid formation does not extend through the entire thickness of the transformation layer (1), so as to form a heat-conducting continuous part of the conversion layer (1).

2. A heat image recording plate according to Claim 1, characterised by the following features : It is used in combination with a shutter which chops up the heat image in terms of time and has a dark phase and a light phase ; the depth of the channels (2) in the conversion layer which form the grid and the thickness of the continuous part of the conversion layer are so dimensioned that the effect of the heat radiation on the grid points penetrates during the light phase up to the continuous part of the conversion layer, and that, during the dark phase, the local distribution of the heat influence in the continuous part of the conversion layer is equalised.

3. A heat image recording plate according to Claim 2, characterised in that the face of the conversion layer (1) which is not formed as a grid is covered with an electrically-insulating layer (4) of high heat conductivity.

4. A heat image recording plate according to one of Claims 1 to 3, characterised in that it consists of a pyroelectric material and is used as a target in a recording tube for thermal images.

5. A heat image recording plate according to one of Claims 1 to 3, characterised in that it consists of a thermoresistive material and is used as a target in a recording tube for thermal images.

6. A heat image recording plate according to one of Claims 1 to 3, characterised in that it consists of a thermoelectric material and is used as a target in a recording tube for thermal images.

**Revendications**

1. Plaque de prise de vue à image thermique, comprenant une couche (1) de transformation, dans laquelle à partir du rayonnement thermique correspondant à une image thermique et incident d'une manière répartie localement une image correspondante à propriété répartie localement est réalisée par l'intermédiaire d'un effet physique de transformation, plaque dans laquelle la couche (1) de transformation est quadrillée par des interruptions de la matière pour empêcher une conduction latérale de la chaleur et les souffles d'image et dans laquelle le quadrillage est du côté du rayonnement thermique incident, caractérisée en ce que le quadrillage ne s'étend pas dans toute l'épaisseur de la couche (1) de transformation, de manière à ce qu'une partie continue et conductrice de la chaleur de la couche (1) de transformation soit formée.

2. Plaque de prise de vue à image thermique selon la revendication 1, caractérisée par les autres caractéristiques suivantes : elle est utilisée en liaison avec un diaphragme à phase obscure et à phase éclairée hachant temporairement l'image thermique ; les profondeurs des canaux (2) formant le quadrillage dans la couche de transformation ainsi que les épaisseurs de la partie continue de la couche de transformation sont dimensionnées de manière à ce que l'effet du rayonnement thermique sur les points du quadrillage a traversé pendant la phase éclairée jusqu'avant la partie continue de la couche de transformation et de manière à ce que, pendant la phase obscure, la répartition locale de l'influence de la chaleur s'égalise dans la partie continue de la couche de transformation.

3. Plaque de prise de vue à image thermique suivant la revendication 2, caractérisée en ce que la partie de la couche (1) de transformation, qui n'est pas quadrillée, est revêtue d'une couche (4) isolante électriquement ayant une conductivité thermique élevée.

4. Plaque de prise de vue à image thermique suivant l'une des revendications 1 à 3, caractérisée en ce qu'elle est constituée en un matériau pyroélectrique et est utilisée comme cible dans un tube de prise de vue pour images thermiques.

5. Plaque de prise de vue à image thermique suivant l'une des revendications 1 à 3, caractérisée en ce qu'elle est constituée en un matériau thermorésistant et est utilisée comme cible dans un tube de prise de vue pour images thermiques.

6. Plaque de prise de vue à image thermique suivant l'une des revendications 1 à 3, caractérisée en ce qu'elle est constituée en un matériau thermoélectrique et est utilisée comme cible dans un tube de prise de vue pour images thermiques.